# EUROPÄISCHE PATENTSCHRIFT

(11) **EP 1 887 844 B1**
(45) Veröffentlichungstag und Bekanntmachung des Hinweises auf die Patenterteilung: **13.06.2012**
(21) Anmeldenummer: 07015094.1
(22) Anmeldetag: 01.08.2007
(51) Int. Cl.: H05K 1/02, H05K 3/22, H05K 3/32, H05K 5/02, H05K 7/02, H05K 7/06, H05K 13/06, B60R 16/023, H05K 1/18, B60R 16/02, H05K 5/00

(54) **Verdrahtete elektromechanische Baugruppe und Verfahren zu ihrer Herstellung**
Wired electro-mechanical components and method for their manufacture
Composants électromécaniques filaires et leur procédé de fabrication

(30) Priorität: 02.08.2006 DE 102006037159
(43) Veröffentlichungstag der Anmeldung: 13.02.2008
(73) Patentinhaber: Oechsler Aktiengesellschaft, 91522 Ansbach (DE)
(72) Erfinder: Heinz, Jürgen, 91541 Rothenburg (DE)
(74) Vertreter: Führing, Dieter

(56) Entgegenhaltungen:
- DE-A1- 2 113 195
- DE-U- 1 865 150
- US-A- 4 899 439
- US-B1- 6 429 515

## Beschreibung

Die Erfindung betrifft einen Komponententräger und ein Verfahren zum Herstellen einer elektrischen Baugruppe gemäß dem jeweiligen Oberbegriff der beiden Hauptansprüche.

Derartige Maßnahmen sind aus der DE 1 865 150 U bekannt. In einem Fernmeldegerät sind dort einander kreuzend blanke Schaltungsdrähte in unterschiedlichen Ebenen parallel zu einer Trägerplatte über Pfosten unterschiedlicher Höhen hinweg linear verlegt. Die einzelnen Schaltungsdrähte greifen, zu ihrer mechanischen Festlegung durch elastisches Verklemmen, mit im Drahtverlauf vorgeformten Schlaufen in Öffnungen ein, die dafür in der Trägerplatte oder in den Stirnflächen der Pfosten ausgebildet sind. Den Pfosten gegenüber, von der anderen Seite der Trägerplatte her, sind die Anschlüsse von Bauelementen durch Löcher in der Trägerplatte hindurch gesteckt, die dann an ihren Enden mit den sie kreuzenden Schaltungsdrähten verlötet sind.

Ein anderes Verdrahtungsverfahren ist das in DE 2 113 195 A für Fernsprech- und Datenverarbeitungsanlagen beschriebene maschinelle Verlegen von Schaltungsdrähten in einem Kontaktstift-Feld mittels motorisch betriebener Einrichtungen, die einen Schaltungsdraht von einer Vorratsrolle abziehen und um Umlenkstifte herum geführt, unter Abisolieren der Drahtenden, zwischen zwei vorgegebenen Kontaktstiften verlegen, jeweils um diese herum wickeln und am zweiten dieser beiden Kontaktstifte schließlich abschneiden.

Nach der DE 1 854 851 U werden Schaltdrähte mit Lötlackisolation, auch einander berührend kreuzend, auf einer gelochten Schaltungsplatte maschinell jeweils auf direktem Wege (also in dieser Ebene und linear) zwischen zwei Löchern verlegt, in denen sie an ihren beiden Enden mit Stiften an Bauelementen verlötet werden, die von der anderen Seite der Schaltungsplatte her in die Löcher eingreifen.

Bei vorliegender Erfindung handelt es sich auch nicht um die Technologie des Wirebonding bei ungehäust auf Schaltungsträger (Substrate) montierten integrierten Halbleiterschaltungen (IC-Chips), die mittels reibverschweißbarer da extrem dünner und weicher Drähte (typisch nur 25 bis 125 µm stark) auf die sehr kurze Distanz von ihren seitlich am flachen Chip gelegenen Anschlussflächen (Pads) über die benachbarte Seitenkante hinweg an unmittelbar dort beginnende, sich über dem Substrat auffächernde Leiterbahnenstrukturen kontaktiert werden (US 6,560,115 B1, Fig.2), welche je nach geometrischer Komplexität als Stanzgitter (vgl. EP 0 791 961 A2) oder als Kaschierungen ausgebildet sein können. Für den Sonderfall ungewöhnlich langer Bonddrähte ist gemäß der US 6,429,515 B1 vorgesehen, diese über Stützstellen zu verlegen, damit sie gegen mechanische Verformungen und Kurzschlüsse beim Einguss des Substrates mit dem aufgebondeten Chip stabilisiert sind.

Elektromechanische Baugruppen der im Rahmen vorliegender Erfindung betrachteten Art bestehen aus funktionsgerecht miteinander verschalteten elektrischen Komponenten wie insbesondere aktiven und passiven Bauelementen, Modulen aus ihrerseits verschalteten Bauelementen, Steckern, Schaltern, Aktoren wie Motoren und / oder Sensoren.

Für unkomplizierte Leiterbahnengeometrien wie bloße Leitungsverzweigungen hinter Steckanschlußstiften wird ein entsprechend konfiguriertes aber zunächst noch mittels Überbrückungen zusammengehaltenes Blechstanzgitter erstellt und zu lokalem Umspritzen in eine Spritzgußform eingelegt, um nach dieser formschlüssigen Stabilisierung die Überbrückungen zwischen elektrisch nicht zusammenzuschaltenden Blechbahnen freizustanzen. Bei der US 6,560,115 B1 (Fig.3; Fig.5 B/C), oder bei der DE 2 03 07 111 U1 speziell für Kfz-Türschlösser, sind elektromechanische Module mittels derartiger Stanzgitter verschaltet. Komponententräger mit komplexen Leiterbahnenkonfigurationen, zumal mit Kreuzungen in mehreren unterschiedlichen Ebenen, sind aber so nicht wirtschaftlich herstellbar.

Der Erfindung liegt die technische Problemstellung zugrunde, eine wirtschaftliche da technologisch unkritisch herstellbare und mechanisch hoch beanspruchbare Verschaltung von Modulen im vorstehend umrissenen Sinne anzugeben, bei denen es sich also nicht um IC-Chips und deren Bondanschlüsse handelt.

Diese Aufgabe ist erfindungsgemäß durch die jeweilige Kombination der in den Hauptansprüchen angegebenen wesentlichen Merkmale erfüllt. Danach nimmt ein aus isolierendem Kunststoff (beispielsweise PBT-GF30) formgespritzter, mit eingespritztem Anschlussgitter ausgestatteter Komponententräger die untereinander zu verschaltenden Module einer Baugruppe kraftschlüssig (etwa durch Verkleben bzw. Einklemmen) oder formschlüssig (etwa durch Verrasten) derart orientiert auf, daß deren elektrischen Anschlußbereiche von außerhalb des Komponententrägers frei zugänglich sind. Sodann werden die - gegenüber Bonddrähten um Größenordnungen kräftigeren, steiferen und längeren - Schaltungsdrähte (nämlich Starr- oder Litzendrähte von mindestens 0,1 mm² Querschnitt) freischwebend zwischen elektrisch zu verbindenden Anschlußbereichen verlegt und - gegebenenfalls nach vorläufiger form- oder kraftschlüssiger Festlegung - lokal mit den Anschlußbereichen mechanisch sowie elektrisch leitend verbunden, etwa durch Preßpassung, Kleben, Löten oder Schweißen, beispielsweise durch Widerstandsschweißen oder Laserschweißen. Nach diesem Verlegen der Schaltungsdrähte wird der sie umgebende Raum im Komponententräger mit Kunststoff wie Kunstharz, Schmelzkleber, Silikon oder Polyurethanschaum verfüllt. Dafür ist der Komponententräger an seinem Bodenbereich mit ringsumlaufenden Wänden ausgestattet, die sich kastenförmig vorzugsweise bis über die größte Höhe der Module und Pfeiler erstrecken. Wo Module wie etwa Schalter, Sensoren oder Aktoren insbesondere für Zugänglichkeit von außerhalb des gehäuseförmigen Komponententrägers z.B. direkt am Rand des Bodenbereiches zu positionieren sind, kann die umlaufende Spritzgusswand insoweit formangepaßt unterbrochen oder durchbrochen sein, weil hier dann jene Module ein Auslaufen der noch nicht ausgehärteten Vergussmasse verhindern.

Im Gegensatz zu den üblichen Bondtechnologien werden die Schaltungsdrähte also nicht jeweils an den Anschlußbereichen abgetrennt; sie werden sogar typischerweise dem Schaltplan entsprechend über die Anschlußbereiche noch mehrerer anderer Module weitergeführt, wozu sie ununterbrochen freitragend dreidimensional (räumlich, also insbesondere auch in der Höhenlage) geschwungen verlaufen können. Diese Drahtverläufe sind an keine Ebene gebunden, sie können über alle drei Raumkoordinaten beliebige Richtungen einschlagen und sich deshalb auch im freien Raum (in unterschiedlichen Höhenlagen über dem Bodenbereich des Komponententrägers) berührungsfrei kreuzen.

Das abschließende Vergießen erbringt dauerhaften Schutz gegen Umwelteinflüsse unter mechanischer Stabilisierung der Drahtverläufe und zusätzlich ein wünschenswertes Fixieren der Schaltungsmodule auf ihrem Komponententräger. Es braucht dafür keine Spritzgusstechnologie eingesetzt zu werden, das kann durch einfaches Ausgießen mit Kunststoff (vorzugsweise mit 2K-Vergußmasse oder im Macromelt Moulding) erfolgen.

Nach der Erfindung ist insbesondere für in kleinerer Stückzahl bei hoher Variantenvielfalt anfallende einfachere Schaltungen aufgrund vergleichsweise geringer Anzahl miteinander zu verdrahtender Komponenten ein kostengünstiger und mechanisch wie elektrisch zuverlässiger Schaltungsaufbau geschaffen, ohne die Schaltungsentflechtung bis auf kreuzungsfreie Leitungsverläufe herabbrechen zu müssen.

Ein programmgesteuertes Verlegen und gegebenenfalls Anschweißen der Schaltungsdrähte erlaubt mit sehr geringen produktspezifischen Investitionen praktisch ohne Mehraufwand flexible Typenumstellungen bis hin zur Einzelfertigung. Zweckmäßigerweise werden die Schaltungsdrähte in an sich bekannter Weise mittels eines wenigstens halbautomatisch programmgesteuert bewegbaren Greifers unter Abziehen des Schaltungsdrahtes aus einem Vorrat wie von einer Spule unter Befestigen aller Enden der Schaltungsdrähte an den Anschlussbereichen der Module und Anschluss-Stifte durch Festklemmen, Verlöten oder Verschweißen, vorzugsweise aber durch Umwickeln, verlegt.

Im Verlauf der Schaltungsdrähte sind die Stütz-Pfeiler vorgesehen, die am Komponententräger aufragend montiert oder angeformt sind. Sie dienen der mechanischen Stabilisierung der zwischen den Anschlussbereichen ununterbrochen an sich freischwebend verlaufenden Schaltungsdrähte, und dabei insbesondere der Abstandshalterung in Kreuzungsbereichen. Die Schaltungsdrähte können über die freien Stirnenden von in unterschiedlichen Höhen endenden Stützpfeilern verlegt und erforderlichenfalls darauf fixiert werden, etwa durch Aufschweißen auf einen hierfür dort aufgebrachten (schaltungstechnisch gar nicht erforderlichen) Anschlußbereich und / oder durch kraftschlüssiges Festlegen etwa in einer in den Kunststoff eingeformten oder auf den Pfeiler applizierten Klemmkerbe.

Weniger aufwendig ist es, den Schaltungsdraht in seinem an sich zwischen zwei damit zu verschaltenden Modulen freitragenden durchgehenden Verlauf dadurch an einem Pfeiler in definierter Höhe über dem Bodenbereich kraftschlüssig festzulegen, daß er wenigstens einmal um einen solchen Pfeiler herumgewunden und infolge der dadurch auftretenden Preßpassung gehaltert wird. Das kann mit mehreren Schaltungsdrähten an einem einzelnen, hinreichend langen Pfeiler nacheinander in zunehmendem Bodenabstand erfolgen, wodurch deren kurzschlußsicheren gegenseitigen lichten Abstände im Kreuzungsbereich gewahrt sind.

Damit in Kreuzungsbereichen der Schaltungsdrähte auch nicht etwa aufgrund mechanischer (Vibrations-)Beanspruchungen Kurzschlüsse auftreten, können die Drähte zwischen ihren Anschlussbereichen isoliert sein und erst im Zuge des Schweißanschlusses (infolge der Hitze- und Druckeinwirkung) lokal abisoliert werden. Dafür ist es vorteilhaft, Kupferlackdraht zu verwenden. Preisgünstiger ist es aber, gleich unisolierte (blanke) Schaltungsdrähte, beispielsweise Kupfer-, Silber- oder Aluminiumdrähte, zu verlegen. Die werden dann nach ihrer Verlegung zur Isolation insbesondere in Kreuzungsbereichen zweckmäßigerweise mit Isolierlack besprüht.

Zusätzliche Weiterbildungen und Alternativen zur erfindungsgemäßen Lösung ergeben sich aus den weiteren Ansprüchen und aus nachstehender Beschreibung eines auf das Funktionswesentliche abstrahierten, unmaßstäblich vergrößert skizzierten bevorzugten Realisierungsbeispieles zur Erfindung. In der Zeichnung zeigt
- Fig.1: einen Querschnitt durch einen kastenförmigen Komponententräger in bestücktem und verdrahtetem Zustand mit einem Abstands-Pfeiler im Kreuzungsbereich von Schaltungsdrähten und
- Fig.2: Beispiele für Steck- und Wickelbefestigungen für die Schaltungsdrähte.

Der skizzierte Komponententräger 11 ist ein elektrisch isolierendes Spritzgussteil mit Bodenbereich 12, davon aufragenden Abstands-Pfeilem 13 und im Wesentlichen umlaufender Wandung 14. Dieses Gebilde kann auch als Gerätegehäuse oder als Teil eines solchen Gehäuses für eine elektromechanische Baugruppe 16 ausgestaltet sein, insbesondere für ein Kfz-Türschloß. Der Komponententräger 11 ist mit den zur Baugruppe 16 zu verdrahtenden Modulen 15, wie passiven Bauelementen 15.1, aktiven Modulen 15.2 und Sensoren oder Aktuatoren 15.3, bestückt. Die sind kraft- oder formschlüssig auf dem Bodenbereich 12 oder in ihn eingesenkt schocksicher festgelegt. Vom Komponententräger 11 umspritzt und dadurch in ihn eingegossen sind Leiterbahnen-Stanzgitter, die zu durch die Wandung 14 durchragenden Anschlussstiften 17 freigestanzt sind. Derartige Anschlußstifte 17 können aber grundsätzlich auch nachträglich in das Material des Komponententrägers eingedrückt oder eingeschossen werden, wie es von der Technologie der Steckerfertigung als solches bekannt ist; wobei es sich also nicht darum handelt, gemäß US 4,031,612 lediglich einen Draht in eine Weichkomponente hineinzudrücken.

Die Anschlußbereiche 19 sind aufgrund entsprechender Positionierung der Module 15 so gegeneinander versetzt gelegen, daß sie quer zur Hauptebene des Bodenbereiches 12, also in ihren verschiedenen Ebenen zwischen den Wänden 14 dem Bodenbereich 12 gegenüber von oben für Drahtverlegungs- und Schweißroboter zugänglich sind.

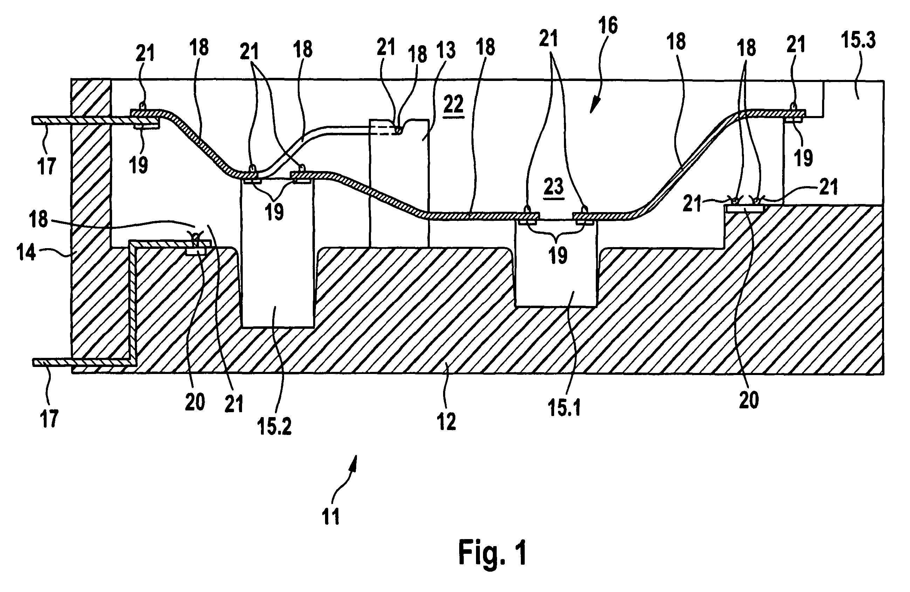

Die Verschaltung der Baugruppe 16 erfolgt mittels Schaltungsdrähten 18 an Anschlußbereichen 19 der Module 15. Diese Anschlußbereiche 19 (und 20) können einfach flächig aufgebrachte Metallisierungen sein; zweckmäßiger ist es jedoch, hierfür metallische (Schneid-)Klemmstellen 21 (etwa gemäß DE 1 03 39 945 A1, Fig3) vorzusehen, in denen der jeweilige, hindurchverlegte und hineingedrückte Schaltungsdraht 18 dadurch schon mechanisch gehaltert bleibt, bis er erforderlichenfalls durch Verkleben, Verlöten oder Verschweißen dort endgültig fixiert wird. Die Schaltungsdrähte 18 führen außerdem an die innenliegenden Enden der aus dem Komponententräger 11 heraus die Wände 14 überragenden Anschlussstifte 17. Auch die Stirnenden der Pfeiler 13 und andere Stellen des Komponententrägers 11 können mit Anschlußbereichen 20 versehen sein, etwa in Form einfach aufgebrachter Metallisierungen oder ebenfalls mit Klemmstellen 21; allerdings hier nicht zu elektrischer Einspeisung, sondern nur zu mechanischer Festlegung der hier vorüberlaufende Schaltungsdrähte 18 (bzw. zum elektrischen Anschluß von Leitungsverzweigungen, wie in Fig.1 rechts berücksichtigt). Wo keine elektrischen Verbindungen erforderlich sind, wie auf den freien Stirnenden der Pfeiler 13, können zum mechanischen Festlegen von hier hinüberlaufenden Schaltungsdrähten 18 wie in Fig. 1 in der Mitte oben skizziert einfach etwa V-förmig Klemmstellen 21 eingeformt sein, um den jeweiligen Schaltungsdraht 18 über den in tieferen Ebenen kreuzenden Schaltungsdrähten 18 auf lichte vertikale Distanz in Position zu halten und dadurch Kurzschlüsse zu vermeiden.

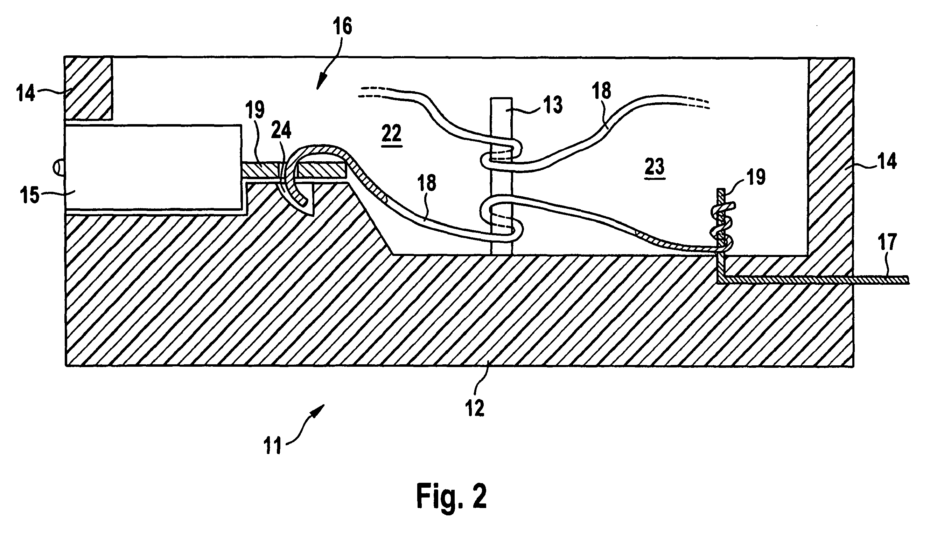

Im Realisierungsbeispiel nach Fig.2 dient einer der Schaltungsdrähte 18 dem elektrischen Anschluß eines Moduls 15, etwa eines Mikroschalters, an einen aus dem Komponententräger 11 herausführenden Anschlußstift 17. Der Modul 15 ist mit einem Anschlußbereich 19 in Form einer gelochten Zunge ausgestattet, unter der eine ihr gegenüber wie skizziert schräg berandete, ohne Hinterschneidung keilförmig nach unten sich verjüngende Drahteingriffs-Freisparung 24 im Bodenbereich 12 des Schaltungsträgers 11 ausgebildet, insbesondere eingeformt ist. Das metallisch blanke Ende des Schaltungsdrahtes 18 wird durch die gelochte Zunge hindurch in die darunter gelegene Aussparung 24 eingesteckt und, wie skizziert der Öffnung der Freisparung 24 gegenüber, über das Stirnende der Zunge hinweg relativ scharfkantig zu einem etwa u- oder v-förmigen Verlauf abgewinkelt. So ist der Schaltungsdraht 18 hier an der Modul-Anschlußzunge unter Preßpassung mechanisch festgelegt und elektrisch angeschlossen.

In seinem weiteren Verlauf wird der Schaltungsdraht 18 dann eng um einen Pfeiler 13 herumgeschlungen und dadurch in dieser Höhe über dem Bodenbereich 12 fixiert, ehe er an einen weiteren Anschlußbereich, hier in Form eines aufragend abgewinkelten inneren Endes Anschlußstiftes 17, verlegt und, dort nun zum mechanischen und auch elektrischen Anschluß, um diesen mehrmals eng herumgewunden wird. Um die bei solcher Wickelbefestigung auftretende Preßpassung noch zu verstärken, weisen der Pfeiler 13 und der Anschlußbereich 19 vorzugsweise keinen runden sondern einen scharfkantigen, etwa einen rechteckigen oder sogar messerförmigen Querschnitt auf. Zusätzlich können die Drahtenden an den Anschlußbereichen 19 verlötet oder verschweißt werden.

In größerem Abstand zum Bodenbereich 12 und dadurch in lichtem Abstand über dem schon am Pfeiler 13 gehalterten Schaltungsdraht 18 ist ein weiterer Schaltungsdraht 18 im Zuge seines Verlaufes um den Pfeiler 13 herumgewunden und dadurch in seinem lichten Kreuzungsabstand zum ersterwähnten, darunter verlaufenden Schaltungsdraht 18 fixiert.

Eine zusätzliche und endgültige Stabilisierung des zunächst freitragenden dreidimensionalen Verlaufes der Schaltungsdrähte 18, 18 über die in verschiedenen Ebenen oberhalb der Hauptebene des Bodenbereiches 12 gelegenen Anschlußbereiche 19, 19, 20 erbringt ein Auffüllen des Freiraumes 22 im fertig verdrahteten kastenförmigen Komponententräger 11 zwischen dessen Wandungen 14 mit Vergußmasse 23. Wo Komponenten 15 wie etwa Sensoren oder Aktuatoren 15.3 in Fig. 1 oder der Mikroschalter (15) in Fig.2 direkt am Rand des Komponententrägers 11 montiert sind, übernehmen diese die Funktion der hier formgerecht unterbrochenen Wandung 14, um ein Auslaufen der noch nicht erhärteten Gußmasse 23 zu verhindern.

Erfindungsgemäß wird also, um insbesondere elektromechanische Baugruppen 16 ohne den technologischen Aufwand der mehrlagigen Leiterplatten für in unterschiedlichen Ebenen berührungsfrei sich kreuzende Leiterbahnen mechanisch und elektrisch zuverlässig zu erstellen, ein im Kunststoffspritzguß etwa kastenförmig geformter Komponententräger 11 so mit den zu verschaltenden Modulen 15 (elektrischen Bauelementen, Sensoren und Aktoren) bestückt, daß deren zu verdrahtenden Anschlussbereiche 19 von einer Seite des Komponententrägers 11 her zugänglich sind, um sie mittels Schaltungsdrähten 18 freitragend zu verbinden, nämlich mechanisch wie auch elektrisch durch Aufschweißen, Einstecken oder Umwickeln daran anzuschließen. In Kreuzungsbereichen können die Schaltungsdrähte 18, 18 unter gegenseitigen Abständen an Pfeilern 13 gehaltert sein. Für den Anschluß nach außen werden Schaltungsdrähte 18 z.B. wie skizziert an in den Komponententräger 11 eingegossene Anschlußstifte 17 geführt. Abschließend wird der Komponententräger 11 zum mechanischen Stabilisieren seiner räumlich fliegenden Verdrahtung und zum mechanischen Schutz seiner Komponenten vergossen. So ist ein umwelt- und vibrationsfester Modul geschaffen, der insbesondere auch zum Einsatz in der Automobilektronik besonders geeignet ist.

### Bezugszeichenliste

- 11: Komponententräger (für 16)
- 12: Bodenbereich (von 11)
- 13: Pfeiler (an 11)
- 14: Wandung (um 12)
- 15: Module (an 11)
- 16: Baugruppe (aus 15-15)
- 17: Anschlußstifte (an 11)
- 18: Schaltungsdrähte (zwischen 15-17 über 13)
- 19: Anschlußbereiche (an 15, 17 für 18)
- 20: Anschlußbereiche (an 11 für 18)
- 21: Klemmstellen (für 18 auf 13 und 20)
- 22: Freiraum (in 11 zwischen 14)
- 23: Vergußmasse (in 22)
- 24: Freisparung (für 18 in 12, unter gelochtem 19)

## Patentansprüche

1. Komponententräger (11) für zu einer elektromechanischen Baugruppe (16) zu verdrahtende Komponenten (15), die am Bodenbereich (12) des Komponententrägers (11) gehaltert sind, mit freitragend durch den Freiraum (22) über dem Bodenbereich (12) sowie über auf den Bodenbereich (12) angeformte Pfeiler (18) unterschiedlicher Höhe verlaufenden Schaltungsdrähten (18), die an Anschlussbereichen (19) der Komponenten (15) befestigt sind, **dadurch gekennzeichnet, dass** er, zusätzlich zu mit ihren Anschlussbereichen (19) von oben frei zugänglichen Komponenten (15) auf oder in dem Bodenbereich (12), mit mindestens einem eingespritzten, nach außen vorragend die Funktion eines Anschlussstiftes (17) realisierenden Stanzgitter ausgestattet ist, das im Innern des Komponententrägers (11) ebenfalls mit einem Anschlussbereich (19) für die Schaltungsdrähte (18) versehen ist, die in ihrem Verlauf an den Pfeilern (18) festgelegt sind, und dass der Bodenbereich (12), wo nicht an seinem Rand eine Komponente (15) als Schalter oder Sensor angeordnet ist, von einer Wandung (14) kastenförmig umgeben ist, innerhalb derer der von Schaltungsdrähten (18) durchzogene Freiraum (22) über dem Bodenbereich (12) von einer Vergussmasse (23) aufgefüllt ist.

2. Komponententräger nach dem vorangehenden Anspruch, **dadurch gekennzeichnet, dass** breitere Anschlussbereiche (19) für Drahtverzweigungen in Form von nebeneinander darauf befestigten Schaltungsdrähten (18) vorgesehen sind.

3. Komponententräger nach einem der vorangehenden Ansprüche, **dadurch gekennzeichnet, dass** Anschlussbereiche (19, 20) an Modulen (15), bei AnschlussStiften (17) oder am Komponententräger (11) bzw. auf seinen Pfeilern (13) mit Klemmstellen (21) für die Schaltungsdrähte (18) ausgestattet sind.

4. Komponententräger nach einem der vorangehenden Ansprüche, **dadurch gekennzeichnet, dass** ein Pfeiler (13) im Zuge des Verlaufes eines Schaltungsdrahtes (18) von letzterem umschlungen ist.

5. Komponententräger nach einem der vorangehenden Ansprüche, **dadurch gekennzeichnet, dass** Löcher für die Enden von Schaltungsdrähten (18) in Anschlussbereichen (19), gegebenenfalls über Drahteingriffs-Freisparungen (24) im Bodenbereich (12) des Komponententrägers (11), vorgesehen sind.

6. Komponententräger nach einem der vorangehenden Ansprüche, **dadurch gekennzeichnet, dass** Anschlussbereiche (19) von Modulen (15) oder AnschlussStiften (17) vom Verlauf bzw. Ende von Schaltungsdrähten (18) umwickelt sind.

7. Komponententräger nach einem der vorangehenden Ansprüche, **dadurch gekennzeichnet, dass** der Schaltungsdraht (18), massiv oder als Litze, einen Querschnitt von mindestens 0,1 mm² aufweist.

8. Komponententräger nach einem der vorangehenden Ansprüche, **dadurch gekennzeichnet, dass** der Bodenbereich (12) eines kastenförmigen Komponententrägers (11), wo nicht an seinem Rand eine Komponente (15) angeordnet ist, von einer Wandung (14) umgeben und der von den Schaltungsdrähten (18) durchzogene Freiraum (22) über dem Bodenbereich (12) von einer Vergussmasse (23) aufgefüllt ist.

9. Verfahren zum Herstellen einer elektromechanischen Baugruppe durch Verdrahten ihrer Komponenten auf einem Komponententräger gemäß einem der vorangehenden Ansprüche, **dadurch gekennzeichnet, dass** die Komponenten bei von oben zugänglichen Schaltungsdraht-Anschlussbereichen (19) am Bodenbereich (12) eines im Kunststoff-Spritzguss erstellten kastenförmigen Komponententrägers (11) befestigt werden, woraufhin die Schaltungsdrähte räumlich freitragend an Stütz-Pfeilern (13) vorbei über die Anschlussbereiche hinweg verlegt und darauf elektrisch leitend befestigt werden ehe der Komponententräger mit Vergussmasse (23) gefüllt wird.

10. Verfahren nach dem vorangehenden Anspruch, **dadurch gekennzeichnet, dass** mindestens ein Anschlussstift (17) nach dem Spritzguss des Komponententrägers in den Kunststoff eingedrückt oder eingeschossen wird.

11. Verfahren nach einem der beiden vorangehenden Ansprüche, **dadurch gekennzeichnet, dass** von einem Greifer ein Schaltungsdraht unter Abziehen aus einem Drahtvorrat nach Festlegen des Drahtendes am Anschlussbereich eines Moduls oder eines Anschluss-Stiftes räumlich freitragend zu wenigstens einem distanziert dazu angeordneten Pfeiler geführt und, in lichtem Abstand zur Höhe anderer Pfeiler, über ihn hinweg geführt wird, ehe dieser Schaltungsdraht dann zu einem anderen Pfeiler oder Anschlussbereich weitergeführt wird.

12. Verfahren nach dem vor-vorangehenden Anspruch, **dadurch gekennzeichnet, dass** von einem Greifer ein Schaltungsdraht unter Abziehen aus einem Drahtvorrat nach Festlegen des Drahtendes am Anschlussbereich eines Moduls oder eines Anschluss-Stiftes räumlich freitragend zu wenigstens einem distanziert dazu angeordneten Pfeiler geführt und um ihn, in lichtem Abstand oberhalb eines anderen etwa schon um diesen Pfeiler verlaufenden Schaltungsdrahtes, herumgeschlungen wird, ehe dieser Schaltungsdraht dann zu einem anderen Pfeiler oder Anschlussbereich weitergeführt wird.

13. Verfahren nach einem der vier vorangehenden Ansprüche, **dadurch gekennzeichnet, dass** die Schaltungsdrähte (18) in ihren Kreuzungsbereichen mit Isolierlack besprüht werden.

## Claims

1. Component carrier (11) for components (15) which are to be wired to form an electromechanical subassembly (16) and are held on the base area (12) of the component carrier (11), having circuit wires (18) which run in a self-supporting manner through the clearance (22) above the base area (12) and via columns (13) of different height integrally formed on the base area (12) and are fastened to connection areas (19) of the components (15), **characterized in that**, in addition to components (15) on or in the base area (12) which are freely accessible from above with their connection areas (19), the component carrier is provided with at least one injection-moulded leadframe which protrudes outwards, implements the function of a connection pin (17) and is likewise provided, inside the component carrier (11), with a connection area (19) for the circuit wires (18) which are fixed to the columns (13) over their course, and **in that** the base area (12), if a component (15) is not arranged on its edge as a switch or sensor, is surrounded, in a box-like manner, by a wall (14) within which the clearance (22), which is crossed by circuit wires (18), above the base area (12) is filled with a potting compound (23).

2. Component carrier according to the preceding claim, **characterized in that** broader connection areas (19) are provided for wire branches in the form of circuit wires (18) which are fastened thereto beside one another.

3. Component carrier according to one of the preceding claims, **characterized in that** connection areas (19, 20) on modules (15), in connection pins (17) or on the component carrier (11) or on its columns (13) are provided with clamping points (21) for the circuit wires (18).

4. Component carrier according to one of the preceding claims, **characterized in that** a column (13) is encircled by a circuit wire (18) over the course of the latter.

5. Component carrier according to one of the preceding claims, **characterized in that** holes are provided for the ends of circuit wires (18) in connection areas (19), possibly above wire engagement recesses (24) in the base area (12) of the component carrier (11).

6. Component carrier according to one of the preceding claims, **characterized in that** the course or end of circuit wires (18) is wrapped around connection areas (19) of modules (15) or connection pins (17).

7. Component carrier according to one of the preceding claims, **characterized in that** the circuit wire (18), in solid form or as a strand, has a cross section of at least 0.1 mm².

8. Component carrier according to one of the preceding claims, **characterized in that** the base area (12) of a box-like component carrier (11), if a component (15) is not arranged on its edge, is surrounded by a wall (14) and the clearance (22), which is crossed by the circuit wires (18), above the base area (12) is filled with a potting compound (23).

9. Method for producing an electromechanical subassembly by wiring its components on a component carrier according to one of the preceding claims, **characterized in that**, in the case of circuit wire connection areas (19) which are accessible from above, the components are fastened to the base area (12) of a box-like component carrier (11) created during plastic injection-moulding, whereupon the circuit wires are laid in a spatially self-supporting manner past supporting columns (13) across the connection areas and are fastened to the latter in an electrically conductive manner before the component carrier is filled with potting compound (23).

10. Method according to the preceding claim, **characterized in that** at least one connection pin (17) is pressed or injected into the plastic after the component carrier has been injection-moulded.

11. Method according to either of the two preceding claims, **characterized in that**, after the wire end has been fixed to the connection area of a module or of a connection pin, a gripper guides a circuit wire, with removal from a wire stock, in a spatially self-supporting manner, to at least one column arranged at a distance from the module or connection pin and guides the wire at a clear distance from the height of other columns across said column before this circuit wire is then continued to another column or connection area.

12. Method according to the preceding claim, **characterized in that**, after the wire end has been fixed to the connection area of a module or of a connection pin, a gripper guides a circuit wire, with removal from a wire stock, in a spatially self-supporting manner, to at least one column arranged at a distance from the module or connection pin and wraps the wire around the column at a clear distance above another circuit wire, which already runs around this column for instance, before this circuit wire is then continued to another column or connection area.

13. Method according to one of the four preceding claims, **characterized in that** the circuit wires (18) are sprayed with insulating varnish in their intersection areas.

## Revendications

1. Support de composants (11) pour des composants (15) à câbler à un module (16) électromécanique, lesdits composants étant maintenus au niveau de la zone de fond (12) du support de composants (11), avec des fils de connexion (18) s'étendant de façon autoportante à travers l'espace libre (22) par-delà la zone de fond (12) ainsi que par-delà les pattes (13) de différentes hauteurs formées sur la zone de fond (12), lesdits fils étant fixés aux zones de raccordement (19) des composants (15), **caractérisé en ce qu'**il est équipé, en sus des composants (15) librement accessibles par en haut avec leurs zones de raccordement (19), sur ou dans la zone de fond (12), d'au moins une grille découpée injectée réalisant, en saillant vers l'extérieur, la fonction d'une tige de raccordement (17), ladite grille étant également pourvue, à l'intérieur du support de composants (11), d'une zone de raccordement (19) pour les fils de connexion (18) fixés dans leur partie longue aux pattes (13) et que la zone de fond (12) contenant un composant (15) prenant la forme d'un commutateur ou d'un capteur non disposé en bordure est entourée par une paroi (14) en forme de caisson à l'intérieur de laquelle l'espace libre (22) traversé par des fils de connexion (18) est remplie par une masse de scellement (23) par-delà la zone de fond (12).

2. Support de composants selon la revendication précédente, **caractérisé en ce que** des zones de raccordement (19) plus larges sont prévues pour les ramifications de fil sous la forme de fils de connexion (18) fixés côte à côte.

3. Support de composants selon l'une quelconque des revendications précédentes, **caractérisé en ce que** les zones de raccordement (19, 20) sont équipées de points de coincement (21) au niveau des modules (15) pour les tiges de raccordement (17) ou au niveau du support de composants (11) et/ou sur ses pattes (13) pour les fils de connexion (18).

4. Support de composants selon l'une quelconque des revendications précédentes, **caractérisé en ce qu'**une patte (13) est enserrée par un fil de connexion (18) dans la partie longue de ce dernier.

5. Support de composants selon l'une quelconque des revendications précédentes, **caractérisé en ce que** des trous sont prévus dans les zones de raccordement (19) pour les extrémités des fils de connexion (18), le cas échéant dans la zone de fond (12) par-delà les détourés du support de composants (11) prévus pour agripper le fil (24).

6. Support de composants selon l'une quelconque des revendications précédentes, **caractérisé en ce que** les zones de raccordement (19) des modules (15) ou des tiges de raccordement (17) sont entourées par la partie longue et/ou l'extrémité des fils de connexion (18).

7. Support de composants selon l'une quelconque des revendications précédentes, **caractérisé en ce que** le fil de connexion (18), présente une section transversale d'au moins 0,1 mm², réalisée en masse pleine ou en toron.

8. Support de composants selon l'une quelconque des revendications précédentes, **caractérisé en ce que** la zone de fond (12) d'un support de composants (11) en forme de caisson contenant un composant (15) non disposé en bordure est entourée par une paroi (14) et que l'espace libre (22) traversé par les fils de connexion (18) est rempli par une masse de scellement (23) par-delà la zone de fond (12).

9. Procédé de fabrication d'un module électromécanique par câblage de ses composants sur un support de composants selon l'une quelconque des revendications précédentes, **caractérisé en ce que** les composants sont fixés au niveau de la zone de fond (12) d'un support de composants (11) en forme de caisson fabriqué par moulage par injection de matière plastique pour les zones de raccordement de fil de connexion (19) accessibles par en haut, à la suite de quoi les fils de connexion sont écartés physiquement au niveau des pattes d'appui (13) par-delà les zones de raccordement pour être autoportants et fixés de façon électriquement conductrice en remplissant, par-dessus, le support de composants de masse de scellement (23).

10. Procédé selon la revendication précédente, **caractérisé en ce qu'**au moins une tige de raccordement (17) est encastrée ou enclavée dans la matière plastique après le moulage par injection du support de composants.

11. Procédé selon l'une quelconque des deux revendications précédentes, **caractérisé en ce qu'**un fil de connexion est guidé de façon à être physiquement autoportant jusqu'à au moins une patte disposée à cette fin à une certaine distance de lui, par le biais d'un élément de préhension, en tirant sur une réserve de fil après avoir localisé l'extrémité du fil au niveau de la zone de raccordement d'un module ou d'une tige de raccordement et est guidé jusqu'à une autre patte au moins se trouvant à une certaine distance en hauteur pour s'en écarter ensuite avant de guider ledit fil de connexion jusqu'à une autre patte ou jusqu'à une autre zone de raccordement encore.

12. Procédé selon la revendication précédente, **caractérisé en ce qu'**un fil de connexion est guidé de façon à être physiquement autoportant jusqu'à au moins une patte disposée à cette fin à une certaine distance de lui, par le biais d'un élément de préhension, en tirant sur une réserve de fil après avoir localisé l'extrémité du fil au niveau de la zone de raccordement d'un module ou d'une tige de raccordement et est enserré à une certaine distance au-dessus d'un autre fil de connexion s'étendant déjà autour de ladite patte avant de guider ledit fil de connexion jusqu'à une autre patte ou jusqu'à une autre zone de raccordement encore.

13. Procédé selon l'une quelconque des quatre revendications précédentes, **caractérisé en ce que** les fils de connexion (18) sont aspergés de laque isolante au niveau de leurs zones d'intersection.
